# EUROPÄISCHE PATENTANMELDUNG

(11) **EP 0 667 674 A1**
(43) Veröffentlichungstag der Anmeldung: **16.08.1995**
(21) Anmeldenummer: 95101563.5
(22) Anmeldetag: 06.02.1995
(51) Int. Cl.: H03F 3/30, H03F 1/32, H03F 1/30

(54) **Schaltungsanordnung zur Einstellung des Querstroms einer Gegentaktendstufe**

(30) Priorität: 14.02.1994 DE 4404655
(71) Anmelder: SIEMENS AKTIENGESELLSCHAFT, 80333 München (DE)
(72) Erfinder: Irvine, Robert Grant, D-81543 München (DE); Kiehl, Oliver, Dr.-Ing., D-80804 München (DE)

(57) **Zusammenfassung**

Schaltungsanordnung zur Einstellung des Querstroms einer zwei Transistoren (1, 2) entgegengesetzten Leitungstyps aufweisenden, durch ein Eingangssignal (6) angesteuerten Gegentaktendstufe,
- bei der zwei durch das Eingangssignal (6) gesteuerte, entgegengesetzt gleich große Ströme liefernde und über eine steuerbare Last (9, 10) miteinander gekoppelte Stromquellen (7, 8) vorgesehen sind, die ihrerseits jeweils einen der beiden Transistoren (1, 2) der Gegentaktendstufe ansteuern,
- bei der zwei entgegengesetzte etwa gleich große Ströme liefernde Konstantstromquellen (11, 16) vorgesehen sind, die jeweils einen ersten in Diode geschalteten Transistor (12, 15) speisen und daß die Spannungsabfälle an den Laststrecken der weiteren Transistoren (12, 15) zur Ansteuerung der steuerbaren Last (9, 10) vorgesehen ist,
- bei der zu den ersten als Diode geschaltete Transistoren (12, 15) jeweils ein zweiter als Diode geschalteter Transistor (13, 14) in Reihe geschaltet ist.

## Beschreibung

Die Erfindung betrifft eine Schaltungsanordnung zur Einstellung des Querstroms einer zwei Transistoren entgegengesetzten Leitungstyps aufweisenden Gegentaktendstufe.

Eine derartige Schaltungsanordnung ist beispielsweise aus dem Datenblatt NE/SA 5230 der Firma Valvo vom 14. November 1986 bekannt. Dabei wird die Spannung über zwei in Reihe geschalteten, von einem Referenzstrom durchflossenen Dioden mit der Summe der Basis-Emitter-Spannungen der Gegentaktendstufentransistoren verglichen und davon abhängig der Querstrom der Gegentaktendstufe eingestellt. Da die Basis-Emitter-Spannungen der Endstufentransistoren proportional sind zum Logarithmus des sie durchfließenden Stromes, wird demgemäß das Produkt der jeweils durch die Endstufentransistoren fließenden Ströme gegenüber dem Logarithmus des Referenzstroms konstant gehalten. Um die Temperaturabhängigkeit, mit der der logarithmische Zusammenhang zwischen Basis-Emitter-Spannung und Kollektorstrom bei einem Transistor behaftet ist, teilweise zu kompensieren, weisen die Dioden eine entsprechende Temperaturabhängigkeit auf. Zur Erzielung einer höheren Genauigkeit wäre jedoch ein erheblicher, zusätzlicher Schaltungsaufwand notwendig. Darüber hinaus wird bei der bekannten Schaltungsanordnung die Genauigkeit dadurch weiter herabgesetzt, daß sich Laständerungen, die den Strom bei nur einem der beiden Endstufentransistoren beeinflussen, sich infolge der aus der Logarithmierung und anschließenden Addition sich ergebenden Produktbildung insgesamt auf die Einstellung des Querstroms auswirken.

Des weiteren ist aus A. Nosratinia et al., "A High-Drive, High-Swing Buffer Amplifier", IEEE CH 3006-4/91/0000-2220, Seite 2220ff eine Pufferstufe bekannt, die es ermöglicht hohe kapazitive Lasten zu treiben. Die beschriebene Schaltungsanordnung ist platzsparend und kann Lasten bis zu 5000 pF mit einer Slewrate von 2V/us treiben, wobei eine Leistung von nur 0,8 mW verbraucht wird. Jedoch zeigt die Anordnung eine relativ starke Abhängigkeit von der Versorgungsspannung und schlechte Matchingeigenschaften.

Aufgabe der Erfindung ist es, eine Schaltungsanordnung zur Einstellung des Querstroms einer zwei Transistoren entgegengesetzten Leitungstyps aufweisenden, durch ein Eingangssignal angesteuerte Gegentaktendstufe anzugeben, die bei geringem schaltungstechnischen Aufwand eine höhere Genauigkeit aufweist.

Die Aufgabe wird bei einer Schaltungsanordnung der eingangs genannten Art durch den kennzeichnenden Teil des Anspruchs 1 gelöst. Über ein Stellglied die Querströme der Gegentaktendstufe und einer Vergleichsschaltung dahingehend eingestellt, so daß eine aus der Vergleichsschaltung abgeleitete und zu dem Querstrom der Gegentaktendstufe proportionale Größe mit einer Referenzgröße übereinstimmt. Da der Querstrom nicht direkt bei der Gegentaktendstufe selbst bestimmt wird, sondern aus einem Vergleichsnetzwerk abgeleitet wird, wirken sich Laständerungen in keiner Weise aus.

Bei der Erfindung sind als Stellglied zwei durch das Eingangssignal gesteuerte, entgegengesetzt gleich große Ströme liefernde und über eine gesteuerte Last miteinander gekoppelte Stromquellen vorgesehen, die ihrerseits jeweils einen der beiden Transistoren der Gegentaktendstufe ansteuern.

Bevorzugt wird die steuerbare Last aus zwei zueinander gegenphasig angesteuerten Feldeffekttransistoren entgegengesetzten Leitungstyps realisiert, deren Laststrecken einander antiparallel geschaltet sind. Bei einer Ausführungsform der Erfindung enthalt die Vergleichsschaltung eine weitere Gegentaktendstufe, deren Querstrom ermittelt und mit einem Referenzstrom verglichen wird, wobei davon abhängig die Last gesteuert wird.

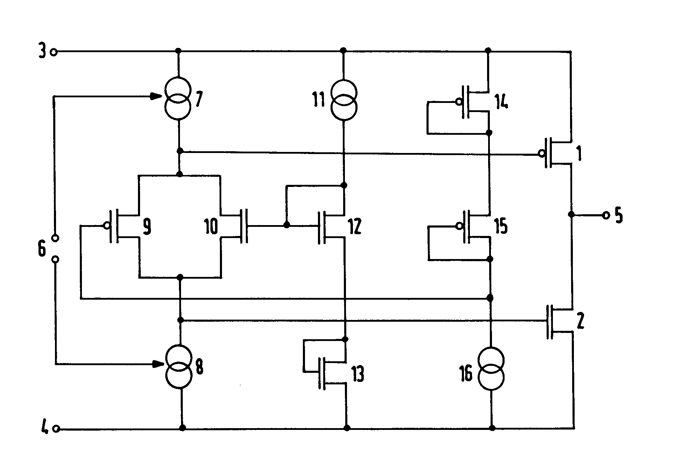

Bei dem Ausführungsbeispiel gemäß der einzigen Figur enthält die Gegentaktendstufe einen MOS-Feldeffekttransistor 1 vom p-Kanal-Typ, dessen Sourceanschluß mit dem positiven Versorgungspotential 3 verbunden ist, und einen MOS-Feldeffekttransistor 2 vom n-Kanal-Typ, dessen Sourceanschluß mit dem negativen Versorgungspotential 4verbunden ist. An den miteinander gekoppelten Drainanschlüssen beider Transistoren ist das Ausgangssignal 5 abnehmbar. Die durch das Eingangssignal 6 angesteuerten Stromquellen 7 und 8 sind bei dieser Ausführungsform jeweils zwischen die Gate- und Sourceanschlüsse der Transistoren 1 und 2 geschaltet. Dabei werden als steuerbarer Widerstand zwei MOS-Transistoren 9 und 10 eingesetzt, die von unterschiedlichem Leitungstyp sind und deren Drain-Source-Strecken einander antiparallel geschaltet sind.

Die Sourceanschlüsse eines MOS-Feldeffekttransistors 14 vom p-Kanal-Typ und eines MOS-Feldeffekttransistors 13 vom n-Kanal-Typ sind dabei jeweils mit den Sourceanschlüssen der Transistoren 1, bzw. 2 verbunden. Der Drainanschluß des Transistors 14 ist mit seinem Gateanschluß und unter Zwischenschaltung einer Diode 15 in Durchlaßrichtung und einer Stromquelle 16 an das negative Versorungspotential 4 angeschlossen. In gleicher Weise ist der Drainanschluß des Transistors 26 über eine Diode 29 in Durchlaßrichtung und eine sistors 13 mit seinem Gatenanschluß und über eine Diode 12 in Durchlaßrichtung und eine Stromquelle 11 mit dem positiven Versorgungspotential 3 verbunden. Der Abgriff zwischen der Diode 15 und der Stromquelle 16 ist mit dem Gateanschluß des Transistors 9 vom p-Kanal-Typ und der Abgriff zwischen der Stromquelle 11 und der Diode 12 mit dem Gateanschluß des Transistors 10 vom n-Kanal-Typ gekoppelt.

Bei der Anordnung gemäß dem Ausführungsbeispiel sind die Transistoren 14 und 13 als Dioden geschaltet. Wenn die Transistoren so dimensioniert sind, daß Transistor 9 die gleiche Gate-Source-Spannung hat wie Transistor 15 und Transistor 10 die gleiche Gate-Source-Spannung wie Transistor 12 hat, dann stellt sich ein zum Querstrom der Transistoren 1 und 2 proportionaler Querstrom ein.

Bei der erfindungsgemäßen Anordnung entfallen die Regelkreise und die zu deren Stabilisierung notwendige Frequenzgangkorrektur. Die erforderliche Genauigkeit der Querstromeinstellung wird durch die Matching-Eigenschaften der Transistoren gegeben. Hierzu ist die Schaltung derart ausgelegt, daß jeweils ein Matching der Transistoren 13 und 2, sowie 14 und 1, sowie 12 und 10, und 9 und 15 miteinander gewährleistet wird. Hierzu können z.B. die Kanallangen Lₙ und die Kanalweiten Wₙ der Transistoren n folgendermaßen dimensioniert werden:
Kanallängen: L_{1 3} = L₂ ; L₁₄ 4 = L₁
L₁₂ = L₁₀ ; _{L}g = L₁₅
Kanalweiten: W_{1 3} = 1/3...1/10 W₂
W₁₄ = 1/3...1/10 W₁
W₁₂ = 1/2...2 W₁₀
W₁₀ = 1/2...2 W₁₂

Dadurch kann gewährleistet werden, daß der Strom I₁₁, der Stromquelle 11 ungefähr gleich dem Strom I₁₆ der Stromquelle 16 und diese gleich 1/3...1/10 des gewünschten Ruhestroms werden.

Steigt der Strom eines Ausgangstransistors an, so wird der Strom des anderen durch die erfindungsgemäße Anordnung gesenkt. Dadurch wird der Querstrom begrenzt.

## Patentansprüche

1. Schaltungsanordnung zur Einstellung des Querstroms eines zwei Transistoren (1, 2) entgegengesetzten Leitungstyps aufweisenden, durch ein Eingangssignal (6) angesteuerten Gegentaktendstufe,
dadurch gekennzeichnet,
- daß zwei durch das Eingangssignal (6) gesteuerte, entgegengesetzt gleich große Ströme liefernde und über eine steuerbare Last (9, 10) miteinander gekoppelte Stromquellen (7, 8) vorgesehen sind, die ihrerseits jeweils einen der beiden Transistoren (1, 2) der Gegentaktendstufe ansteuern,
- daß zwei entgegengesetzte gleich große Ströme liefernde Konstantstromquellen (11, 16) vorgesehen sind, die jeweils einen ersten als Diode geschalteten Transistor (12, 15) speisen und daß die Spannungsabfälle an den Laststrecken der als Diode geschalteten Transistoren (12, 15) zur Ansteuerung der steuerbaren Last (9, 10) vorgesehen ist,
- daß zu den ersten als Diode geschaltete Transistoren (12, 15) jeweils ein zweiter als Diode geschalteter Transistor (13, 14) in Reihe geschaltet ist.

2. Schaltungsanordnung nach Anspruch 1,
dadurch gekennzeichnet, daß die
steuerbare Last zwei zueinander gegenphasig angesteuerte Feldeffekttransistoren (9, 10) enthält, deren Laststrecken einander antiparallel geschaltet sind.

3. Schaltungsanordnung nach Anspruch 2,
dadurch gekennzeichnet, daß die
Feldeffekttransistoren (9, 10) derart dimensioniert sind, daß die Gate-Source-Spannung der Feldeffekttransistoren (9, 10) der steuerbaren Last gleich der der jeweils zweiten als Diode geschalteten Transistoren ist.
